# EUROPEAN PATENT APPLICATION

(11) **EP 3 166 055 A1**
(43) Date of publication of application: **10.05.2017**
(21) Application number: 15382542.7
(22) Date of filing: 05.11.2015
(51) Int. Cl.: G06Q 10/06

(54) **A COMPUTER-IMPLEMENTED METHOD AND SYSTEM FOR SETTING UP AN AIR TRAFFIC SIMULATOR**

(71) Applicant: The Boeing Company, Chicago, IL 60606-1596 (US)
(72) Inventor: Lopez Leones, Javier, 28042 MADRID (ES); D´Alto, Luis Pedro, 28042 MADRID (ES)
(74) Representative: Carvajal y Urquijo, Isabel

(57) **Abstract**

A computer-implemented method and a system for setting up an air traffic management (ATM) simulator in an airport are described herein. The method performs the steps of receiving a set of undetermined parameters and rules (112) for configuring an ATM simulator (114) in an airport; retrieving a historical data set of variables associated with trajectory and aircraft states in an airspace region during a time interval; statistically analyzing the historical data set for modelling the airspace region and the airport, and identifying relationships between variables of the historical data set during the time interval relating to at least one undetermined parameter or rule (112); determining a parameter value (160) or rule (140,170) for configuring the ATM simulator corresponding with the at least one identified relationship.

## Description

### FIELD

The present disclosure is comprised in the field of air traffic simulators. More particularly, the present disclosure relates to a method and system that use historical data to deploy a simulator in a particular airspace region.

### BACKGROUND

The deployment of air traffic simulator in a particular airspace region (e.g., airport, sector, flight information region (FIR)) requires firstly a description in terms of routes, waypoints, runways, departure and landing procedures, or terrain obstacles and secondly a manual calibration of the traffic simulation to create the rules that applies to that region in certain conditions.

Currently, when an air-traffic simulator is deployed, all the simulation rules and parameters need to be adjusted manually by means of creating and running different simulated scenarios that mimic or not real traffic. As a result, the deployment of a simulator is a time-consuming task that needs a great deal of resources. It demands a constant interaction of a simulator operator with ATCos (Air Traffic Controllers) to identify rules followed to adjust the traffic flow according to changing environmental conditions or the capacity of the airport. Then the simulator operator needs to manually code all the different rules from scratch and set all the different simulator parameters to the particular airspace region. Apart from time and cost, unrealistic setups and sensitivity to errors are other significant drawbacks of this manual solution. Therefore, there is a need for a solution to facilitate the deployment of an air traffic simulator in an airspace region.

### SUMMARY

The present disclosure refers to a computer-implemented method and system to deploy an air traffic management (ATM) simulator making use of historical data related to airspace activity.

A quick setup of the ATM simulator can be achieved by automatically identifying parameters and rules that are undetermined. Two types of rules can be defined. ATCo rules represent ATCo interventions on the future flown trajectory. They can be applied to a set of flights under a certain circumstance and they are mainly used for deconfliction and sequencing. An example of an ATCo rule would be "reduce speed to 200 knots when reaching waypoint QRT"

Operational Context rules are related to the airspace layout. They mainly affect the available routes and airport configuration, stablishing which routes, runways or procedures can be used by the different flights from those published in the aviation charts and included in the operational context model used by the simulator. Examples of operational context rules are "runway 33L available for departure aircraft from 09:00AM until 14:00PM", "route ABC unavailable from 13:00PM until 21:00PM on date 10-Oct-2015", or "airport LEMD in West configuration from 13:00PM until 18:00PM". In many cases, operational context rules are in place due to some weather condition (e.g., wind changes, storms) or some external condition that obliges to close or modify the current predefined airspace (e.g., war condition in an area, congestion in a sector). A parameter of the ATM simulator refers to different configuration setups that apply to all the flights in all the simulations, independently on the scenario run or reconstructed. Examples of these parameters could be the taxiing speed for the different aircraft types or the minimum separation distance used for sequencing and conflict detection.

By obtaining these parameters and rules from available historical data, interactions of the simulator operator with the ATCo may be favorably avoided.

Historical data can be retrieved from a plurality of sources depending on the type. The present disclosure proposes retrieving information (variables associated with trajectory and aircraft states) from these sources in order to obtain historical data set that apply to the airspace region and processing said historical data set to infer rules and parameters used by the ATM simulator. The historical data set is statistically analyzed for modelling the airspace region and the airport, thus relationships between variables of the historical data set can be identified to determine a parameter value or rule for configuring the ATM simulator.

Advantageously new features may be implemented, in addition to identification of rules and automatic setup of simulator parameters, links between changes in the traffic and environmental conditions and adjustment in the simulation parameters may be offered. These and other features, functions, and advantages that have been discussed can be achieved independently in various embodiments or may be combined in yet other embodiments further details of which can be seen with reference to the following description and drawings.

### BRIEF DESCRIPTION OF THE DRAWINGS

A series of drawings which aid in better understanding the disclosure and which are expressly related with an embodiment of said disclosure, presented as a non-limiting example thereof, are very briefly described below.
Fig. 1 schematically depicts a block diagram according to an exemplary embodiment.
Fig. 2A shows a lateral profile of arriving traffic into airport A.
Fig. 2B shows a vertical profile of arriving traffic into airport A.
Fig. 3A shows a lateral profile of departing traffic from airport A.
Fig. 3B shows a vertical profile of departing traffic from airport A.
Fig. 4 depicts an arriving composition by type of aircraft into airport A.
Fig. 5 depicts a departing composition by type of aircraft from airport A.
Fig. 6 is a table of an airport configuration distribution of airport A with number of arrivals and departures.
Fig. 7 is a representation of air traffic arriving into airport B - runway 32L/32R (North configuration) during a 5-day period.
Fig. 8 is a table illustrating distribution of airport B with number of arrivals for a given STAR.

### DETAILED DESCRIPTION

Embodiments of systems and methods for setting up an ATM simulator are described herein. One skilled in the art will understand that the present disclosure may have additional features or may be practiced without several of the details shown in the following description.

In most cases, airspace constraints can be classified as those coming from the ATCo's instructions and those coming from the airspace structure. The airspace constraints due to the airspace structure are referred to as operational context.

Operational context includes waypoints, legs, routes, aerodromes, SIDs (Standard Instrument Departure), STARs (Standard Terminal Arrival Route), runways, altitude and speed constraints, etc. Operational context may be considered static.

ATCo's instructions are normally related to ensure the safe and efficient flow of aircraft (e.g., busy period with traffic coming from a particular airspace region; changes in the weather conditions; emergency situation with a particular runway blocked, etc). ATCo's instructions usually modify intended aircraft trajectories.

The term trajectory is used to describe the set of all aircraft states throughout the flight, typically assuming discrete time intervals between successive states and with the aircraft state including not only the three-dimensional position of the aircraft's center of mass but also other variables of interest, such as time, longitude, latitude, pressure altitude, calibrated airspeed, true airspeed, ground speed, rate of climb, heading, bank angle, instantaneous mass, engine thrust, flown distance, geometric flight path angle, Mach number, flap setting, landing gear, speed brakes, fuel flow, kg/min, geometric altitude, wind components (North, East), bearing (track angle), and aerodynamic flight path angle.

Trajectory data can be obtained among other sources from radar tracks, ADS-B (Automatic Dependent Surveillance-Broadcast) or QAR and ANSPs (Air Navigation Service Providers).

The flight plan is the standard way for describing the aircraft's intended (i.e. nominal) trajectory.

Flight plans provide with basic information such as estimated departure time and estimated arrival time, cruising speed, departure and arrival airports, estimated time en-route or type of aircraft. There are likely to be many aircraft trajectories that would satisfy a given flight plan.

Flight plans are usually available from ANSPs, Airlines or Eurocontrol.

Deviations in the execution of respective flight plans are useful to identify an intervention by the ATCo (i.e. airspeed/altitude schedules, path shortening, path stretching and holding pattern instances). Thus, frequent interventions (having a frequency over a threshold) may be implemented as a rule in the set-up of the ATM simulator.

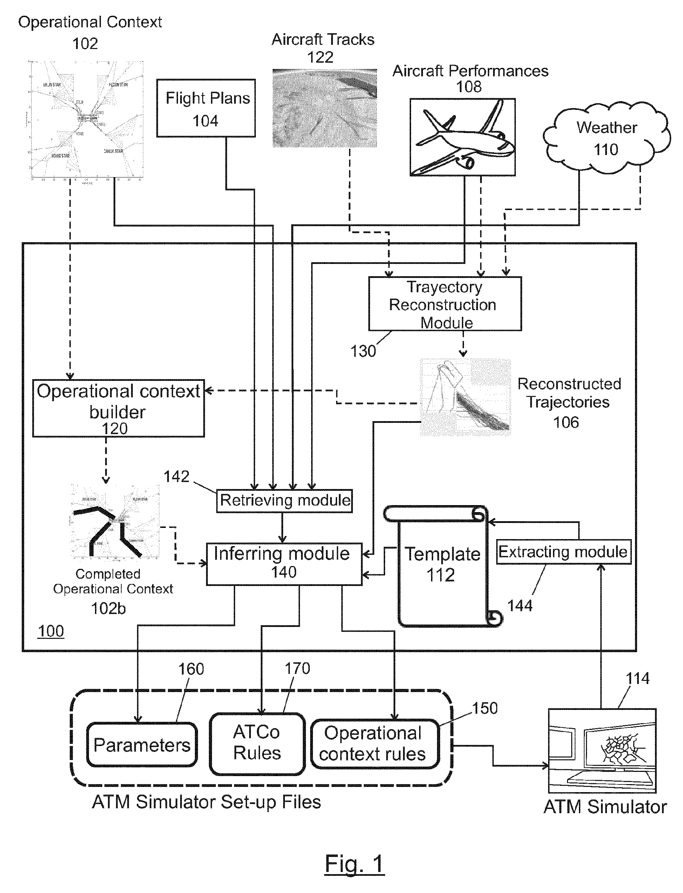

In FIG. 1 a system **100** for setting up an ATM simulator is shown. The system **100** comprises an inferring module **140,** a trajectory reconstruction module **130** and a retrieving module **142** retrieves historical data set of variables relating to trajectory and aircraft states in the airspace region during a time window.

The system **100** further comprises an extracting module **144** for extracting a set of undetermined parameters and rules **112** for configuring an ATM simulator **114** in an airport. The inferring module **140** configured to statistically analyze the historical data set for modelling the airspace region and the airport to identify relationships between variables of the historical data set during the time interval relating to at least one undetermined parameter or rule **112,** wherein the inferring module **140** is further configured to determine a parameter value **160** or rule **150** or **170** for configuring the ATM simulator corresponding with the at least one identified relationship. For example, the inferring module **140** may identifying at least one relationship between historical data of aircraft speed and aircraft distance from the runway as obtained from the historical data set, and determine an ATC rule associated with a maximum aircraft speed for an aircraft that is within 20 NM of the runway, where the ATC rule for maximum aircraft speed, corresponding with the at least one identified relationship between aircraft speed and distance from the runway, is used for configuring the ATM simulator. The extracting module **144,** retrieving module **142** and inferring module **140** may comprises a module that is executed or implemented in computer system, and may be implemented as program code, hardware, or a combination of the program code and hardware. For example, the modules may be implemented in program code configured to run on hardware, such as a processor unit that executes program instructions stored on a memory device coupled to the processor.

The input elements of the system **100** are:
▪ Published operational context **102;**
▪ Flight plans **104;**
▪ Aircraft tracks **122;**
▪ Aircraft performance data **108;**
▪ Weather conditions **110.**

Aircraft tracks **122,** aircraft performance **108** and weather information **110** are used to reconstruct the full aircraft state for each trajectory (speeds, thrust setting, rate of climb, etc.).

A template **112** is obtained by an extracting module **144** from the ATM simulator **114** (this is done once). The template **112** may include all the possible parameters **170,** ATCo rules **160,** operational context rules **150** that can be specified in the setup.

The parameters and rules of this template **112** may be advantageously specified using the same elements and variables that are used to build the operational context **102b** and the reconstructed trajectories **106.** This is needed for the machine learning algorithm within the inferring module **140.**

Using the flight plans **104,** weather conditions **110** at a given time interval, aircraft performance model **108** and completed operational context **120b,** the inferring module **140** computes the nominal trajectories and compares them in all the variables to the reconstructed trajectories.

According to defined threshold, different rules may be used to match the nominal trajectories with the reconstructed trajectories. Those rules that are consistently repeated under equivalent conditions (e.g., weather, aircraft type, route, waypoint,...) will be part of either ATCo rules (if the rule is affecting directly the trajectory) or operational context rule (if the rule affect the airport layout, such as changes in the runway configuration. Also, parameters may be identified, for instance the minimum separation distance applied to the different aircraft categories.

Accordingly, historical trajectory data may be obtained through a trajectory reconstruction module **130.** The trajectory reconstruction module **130** infers trajectories from several sources. Specifically, aircrafts tracks **122,** flight plans **104,** aircraft performances **108** and weather conditions **110** may be employed to this purpose.

As to the sources, aircraft tracks **122** can be obtained from ADS-B reports. Weather conditions **110** (pressure, temperature, wind, etc) are normally key information that may be obtained from different sources. Principally, two authorities provide such information: the European Centre for Medium-Range Weather Forecasts (ECMWF) and the Global Weather System (GFS) of the National Oceanic and Atmospheric Administration (NOAA). Flight plans **104** are available from ANSPs. Aircraft performances **108** are also obtainable from databases (internet, manufactures, ANSP's). Performances information may include thrust, climb speeds, drag or maximum speed of aircrafts.

Optionally, an operational context builder module **120** may be also part of the system. The operational context builder module **120** may enrich the published operational context **102** of a given airport through reconstructed trajectory information **106** to provide a completed operational context **120b.** In this regard, the completed operational context **120b** may include non-published (or non-public available) procedures applied consistently at the airport, for example new SIDs or STARs procedures.

The operational context builder module **120** provides the inferring module **140** with the completed operational context **102b** along with the reconstructed trajectories **106.** When possible, information from nominal flight plans **110,** aircraft performances **108** and weather database **116** is also used as an input for the inferring module **140.** Nominal flight plans **104,** aircraft performances **108** and weather conditions **110** are of use not only to reconstruct trajectories but also to infer rules and parameters for setting-up the ATM simulator.

Depending on the type of simulator, specific parameters and rules are required. These may be specified as a template to be fulfilled.

The inferring module **140** can infer a rule by applying machine learning techniques or pattern recognition.

Typical parameters that are needed to set up and deploy an ATM simulator are: the airport layout (number, position and direction of the runways), SIDs and STARs definitions or holding areas.

Typical ATCo rules are: "merge all the traffic from a particular direction to a metering fix", or "change the runway configuration depending on the weather". The parameters and rules obtainable depend on the amount of available information.

More complex rules require more information and statistical analysis. For instance, some of the variables below are included in parentheses since they may be considered for deducing more complex rules, whereas they may put aside for deducing simpler rules.
- Airport configuration, depending on weather conditions (and optionally time slot).
- Lateral route in the form of airways or waypoints, depending on origin, destination, (weather conditions, aircraft type, operator).
- Cruising altitude depending on origin and destination (and optionally on route, weather conditions, aircraft type or operator).
- Speed depending on origin and destination, (and optionally on route, weather conditions, aircraft type or operator).
- Departure procedure depending on airport configuration and destination (and optionally on route, weather conditions, aircraft type or operator).
- Arrival procedure, depending on airport configuration, origin, (and optionally on route, weather conditions, aircraft type or operator).
- Spatial / temporal separation between two consecutive aircraft, depending on types of aircrafts (and optionally on weather).

### EXAMPLE 1

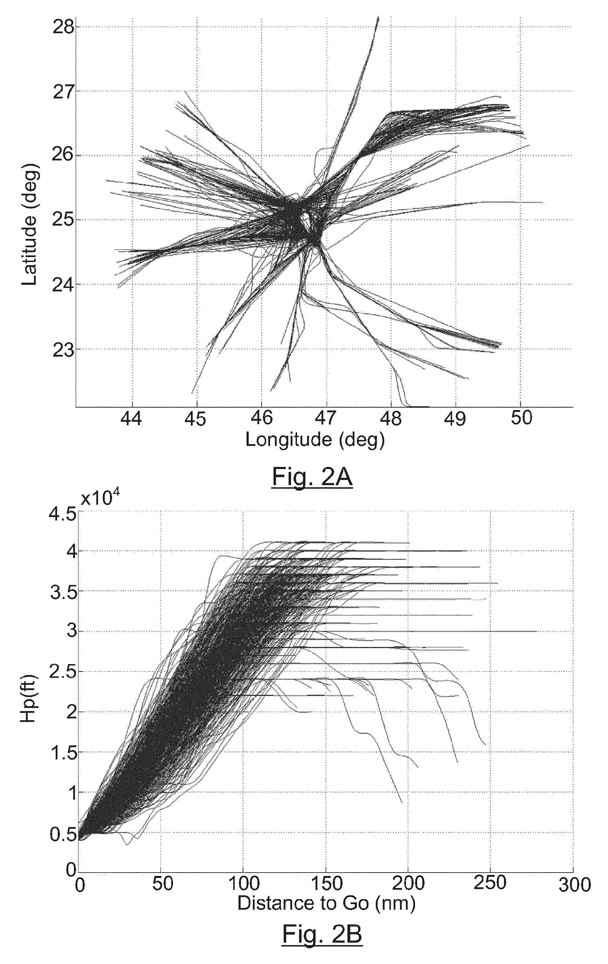

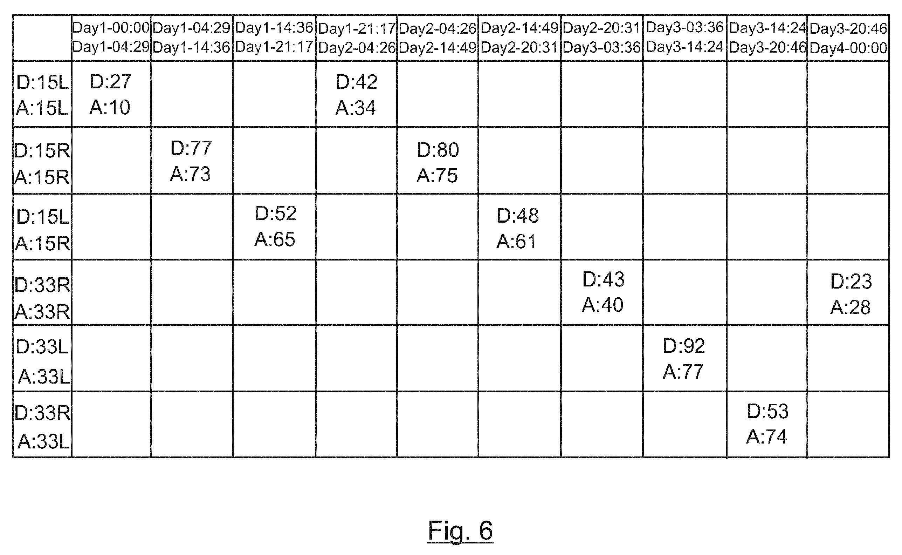

For a better understanding of the disclosure, reference is made to FIGS. 2 to 6 relating to a first example where trajectory data is obtained from ADS-B for a certain airport, namely airport "A" which has two parallel runways: runway 15L/15R and runway 33L/33R. No SIR or STAR are defined in the operational context.

Historical data proceeds from ADS-B reports collected in the airport A during a 72-hour window (period between DAY 1 at 00:00 AM and DAY 4 at 00:00 UTC).

### ADS-B reports

These reports are originated from the ADS-B equipped/enabled aircraft flying within the range of the ADS-B receiver equipment (approx. 200 nmi). As such, the ADS-B pool of data may include reports from many aircraft that are not flying into/from this airport (flights en-route within range, flights bound to/from nearby airports, etc.), and exclude all information about non-ADS-B equipped/enabled aircraft. It is assumed that the reference ADS-B dataset used includes all aircraft flying in and out of this airport during the time interval of interest.

ADS-B reports include information about the aircraft state. In particular, the following information is collected from the ADS-B reports:
▪ Timestamp.
▪ Position (latitude/longitude).
▪ Barometric altitude (w.r.t standard mean sea level pressure).
▪ Ground speed.
▪ Aircraft type (ICAO designator).
▪ Call sign.

ADS-B reports are broadcast by aircraft approximately every 5 seconds, although many reports can go missing depending on atmospheric conditions and distance to the receiver, among other factors.

### Flight plans

Flight plans indicate estimated departure time and estimated arrival time, cruising speed, departure and arrival airports, estimated time en-route or type of aircraft.

Among the items included in the flight plan is information related to both horizontal and vertical profiles. The sequence of waypoints and the alternative aerodromes are considered horizontal-profile inputs, whereas the desired cruise altitude and speed are related to the vertical profile.

### Trajectories extraction

In a first step, tracks of all the flights contained in the ADS-B data pool of reports are univocally identified and extracted. Only track reports **122** corresponding to flights that are indeed flying into/from this airport A are selected. These track reports **122** are the key inputs to a second processing step of trajectory reconstruction by the trajectory reconstruction module **130.**

Univocally identifying and extracting the set of track reports **122** corresponding to each flight may be accomplished by indexing the pool of ADS-B reports by aircraft type and call sign. All track reports **122** having such identical attributes are grouped as corresponding to the same flight. The timestamp history of each candidate group of tracks reports is then analyzed, and each candidate group is split into separate subgroups at the occurrence of time gaps larger than a given specification (300 sec for this example).

The resulting groups of tracks are then cropped to include reports with positions no further than 200 NM from this airport. Selection of flights flying into/from the airport A is accomplished by retaining only those groups of tracks that would have at least one sample within a 4 NM radius area from the airport A and at most 1000 m above the airport elevation, and another sample farther than 40 NM from the airport A. The resulting tracks were then cropped to altitudes greater than or equal to 1000 m.

### Composition

As a result, a total of 1074 flights with corresponding ADS-B tracks are identified as flying into/from the airport A during the 72-hour target window: 537 arrivals and 537 departures.

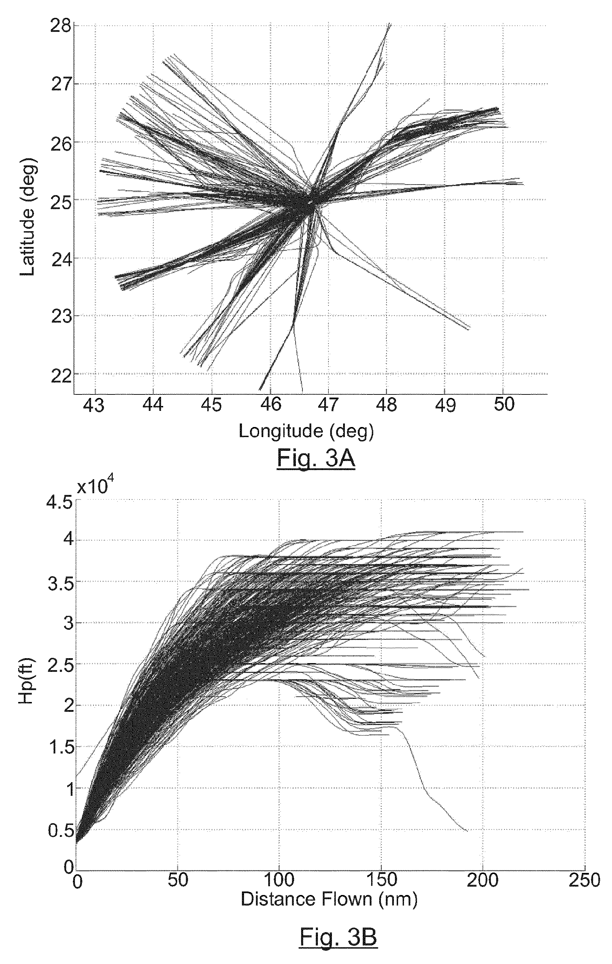

FIGs. 2 and 3 show the resulting tracks (lateral and vertical profiles as extracted from the processed ADS-B tracks and separated into departing and arriving traffic).

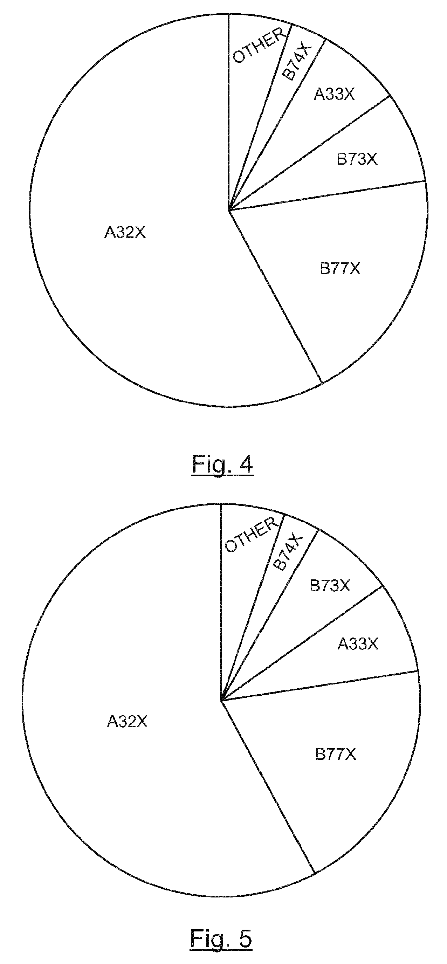

The pie charts in FIGs. 4 and 5 show the fleet composition of the arriving and departing flights respectively according to the type of aircraft. For instance, this may be useful for identifying rules or parameters that depend on the aircraft type.

### Weather conditions

During the target window northerly winds blow from DAY-1 00:00 UTC to DAY-2 20:31 UTC, whereas southerly winds blow from DAY-2 20:31 UTC to DAY-4 00:00 UTC.

### ATCo Rules and Operational Context rules

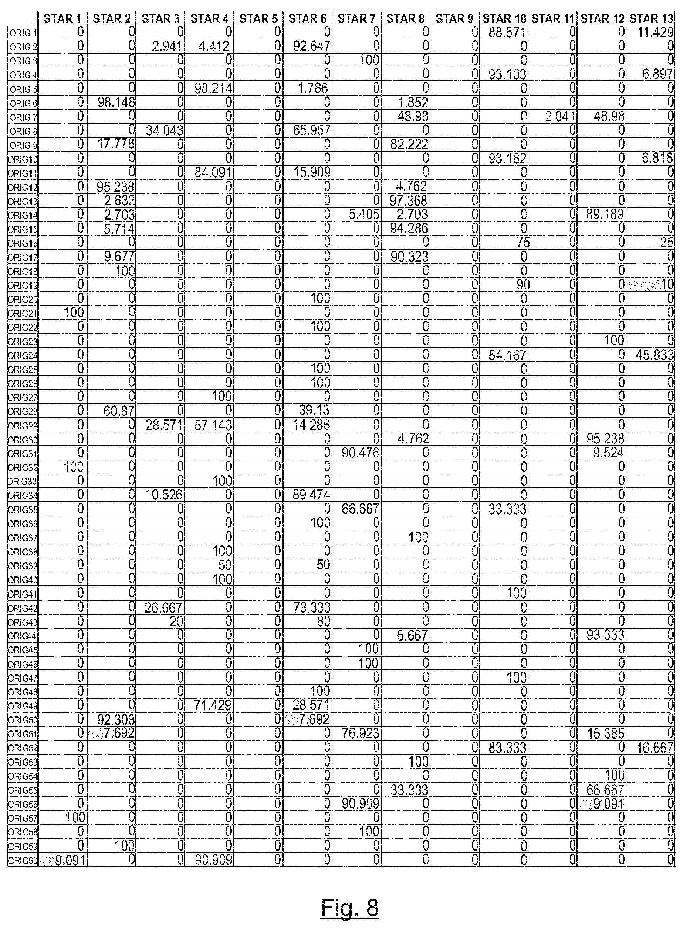

The airport A operates either employing one single runway for both arrivals and departures, or one runway for arrivals and the other for departures. This is shown in a table in FIG. 8. With this information, a template 112 for the ATM simulator 114 may be fulfilled with the following information.
Parameters **170:** 1 parameter was identified
1. Minimum aircraft separation is 5 NM
ATC rules **160:** 1 rule was identified
1. If an aircraft is 20 NM or more closer to the runway, the maximum speed is 200 knots or lower
Operational Context Rules **150:** Three rules were identified
1. Airport A North configuration:
   - Use runway 15L for departures and arrivals from 20:30 to 04:30
   - Use runway 15R for departures and arrivals from 04:30 to 14:30
   - Use runway 15R for arrivals and 15L for departures from 14:30 to 20:30
2. Airport A South configuration:
   - Use runway 33R for departures and arrivals from 20:30 to 04:30
   - Use runway 33L for departures and arrivals from 04:30 to 14:30
   - Use runway 33L for arrivals and 33R for departures from 14:30 to 20:30
3. When the wind vector north component is higher or equal to 0 knots, the airport will run in North Configuration

Accordingly, by extracting aircraft speed from performance data **108** and aircraft distance from aircraft tracks **122,** the computer implemented method can determine relationships between variables by identifying at least one relationship between aircraft speed and aircraft distance from the runway as obtained from the historical data set, and can determine a parameter value or rule by determining an ATC rule **160** associated with a maximum aircraft speed for an aircraft that is within 20 NM of the runway, where the ATC rule **160** corresponding with the at least one identified relationship is used for configuring the ATM simulator.

### EXAMPLE 2

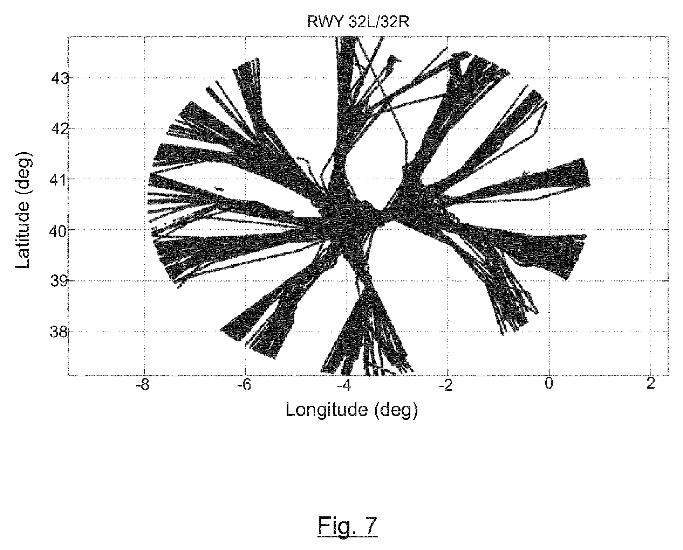

A second brief example is presented below. Only arriving traffic in another airport, namely airport "B" in a given runway is analyzed during a 5-day period to deduce some rules and parameters for setting up an ATM simulator. Reference is made to figures 7 and 8. In this example, it can be seen that most origins are strongly related to a corresponding single STAR.
Parameters **170:**
Minimum aircraft separation is 5 NM
ATC rules **160:**
Aircraft from Origin 1 assigned 83% of the time to STAR and 17% of the time to STAR
Aircraft from Origin 2 assigned 93% of the time to STAR 6, 3% of the time to STAR 3 and 4% of the time to STAR 4.

The rest of the equivalent rules can be derived from Figure 8
Operational Context Rules **150:**
STAR 48 only available from 24:00 to 08:00.
STAR 58 only available from 24:00 to 08:00.

## Claims

1. A computer-implemented method for setting up an air traffic management (ATM) simulator in an airport, comprising:
- receiving a set of undetermined parameters and rules (112) for configuring an ATM simulator (114) in an airport,
- retrieving a historical data set of variables associated with trajectory and aircraft states in an airspace region during a time interval,
- statistically analyzing the historical data set for modelling the airspace region and the airport, and identifying relationships between variables of the historical data set during the time interval relating to at least one undetermined parameter or rule (112),
- determining a parameter value or rule for configuring the ATM simulator corresponding with the at least one identified relationship.

2. The computer-implemented method of claim 1, wherein the historical data set comprise weather conditions (110) during the time interval, and the step of statistically analyzing the historical data further comprises identifying changes in weather conditions (110) associated with a different airport configuration to determine an operational context rule (150) for configuring the ATM simulator (114).

3. The computer-implemented method of claim 1 or 2, wherein the historical data comprise aircraft tracks (122) and flight plans (104) arriving at or departing from the airport and the step of statistically analyzing the historical data set further comprises:
- comparing flight plans (104) with corresponding aircraft tracks (122),
- identifying deviations in the execution of flight plans (104), and
- associating said deviations with an air traffic control (ATCo) intervention to determine an ATCo rule (170) for configuring the ATM simulator (114).

4. The computer-implemented method of any of previous claims 1 to 3, wherein it further comprises:
- reconstructing the trajectories of a plurality of flights according to recorded aircraft tracks (122), aircraft performance information (108) and weather conditions (110) during the time interval;
- analyzing lateral and vertical profiles using pattern recognition in the reconstructed trajectories (106) to set a parameter (160) or infer an operational context rule (150) for configuring the ATM simulator (114).

5. The computer-implemented method of claim 4, wherein it further comprises refining the operational context rule by further analyzing historical data according to flight origin to infer an arrival procedure in the airport.

6. The computer-implemented method of claim 4, wherein it further comprises refining the operational context rule by further analyzing historical data according to flight destination to infer a departure procedure in the airport.

7. The computer-implemented method of claims 5 or 6, wherein refining the operational context rule by further analyzing historical data considers at least one of the following information: weather conditions, route, aircraft type, flight operator, time schedule or a combination thereof.

8. The computer-implemented method of claim 1, wherein identifying relationships between variables comprises identifying at least one relationship between historical data of aircraft speed and aircraft distance from the runway as obtained from the historical data set, and wherein determining a parameter value or rule comprises determining an ATCo rule associated with a maximum aircraft speed for an aircraft that is within 20 NM of the runway, based on the historical data, where the maximum aircraft speed is used as a rule for configuring the ATM simulator, corresponding with the at least one identified relationship between aircraft speed and aircraft distance from the runway.

9. The computer-implemented method of claim 1, wherein identifying relationships between variables comprises identifying at least one relationship in the form of deviations between flight plans (122) and corresponding aircraft tracks (122) obtained from the historical data set, which deviations relate to at least one undetermined parameter or rule (112) of an intervention by the ATCo, and determining a parameter value or rule comprises determining a rule associated with an intervention by the ATCo based on deviations between flight plans (122) and corresponding aircraft tracks (122), where intervention having an frequency of occurrence over a threshold is implemented as a rule that is used for configuring the ATM simulator.

10. A system for setting up an air traffic management (ATM) simulator in an airport, comprising:
- an extracting module (144) for extracting a set of undetermined parameters and rules (112) for configuring an ATM simulator (114) in an airport,
- a retrieving module (142) for retrieving a historical data set of variables associated with trajectory and aircraft states in an airspace region during a time interval,
- an inferring module (140) configured to statistically analyze the historical data set for modelling the airspace region and the airport to identify relationships between variables of the historical data set during the time interval relating to at least one undetermined parameter or rule (112), wherein the inferring module (140) is further configured to determine a parameter value (160) or rule (150,170) for configuring the ATM simulator corresponding with the at least one identified relationship.

11. The system of claim 10, wherein the historical data set comprise weather conditions (110) during the time interval, and the inferring module (140) is configured to identify changes in weather conditions (110) associated with a different airport configuration to determine an operational context rule (150) for configuring the ATM simulator (114).

12. The system of claims 10 or 11, wherein the historical data comprise aircraft tracks (122) and flight plans (104) arriving at or departing from the airport and the inferring module (140) is configured to compare flight plans (104) with corresponding aircraft tracks (122), to identify deviations in the execution of flight plans (104) and to associate said deviations with an air traffic control (ATCo) intervention to determine an ATCo rule (170) for configuring the ATM simulator (114).

13. The system of any of previous claims 10 to 12, further comprising a trajectory reconstruction module (130) configured to reconstruct the trajectories of a plurality of flights according to recorded aircraft tracks (122), aircraft performance information (108) and weather conditions (110) during the time interval, wherein the trajectory reconstruction module (130) is coupled with the inferring module (140) for analyzing lateral and vertical profiles using pattern recognition in the reconstructed trajectories (106) in order to set a parameter (160) or to infer an operational context rule (150) for configuring the ATM simulator (114).

14. The system of claim 13, wherein it further comprises an operational context builder (120) configured to enrich the operational context (102) wherein the operational context builder (120) is coupled with the inferring module (140) to refine an inferred operational context rule (150) by further analyzing historical data according to:
- flight origin in order to infer an arrival procedure in the airport, or
- flight destination in order to infer a departure procedure in the airport.

15. The system of claim 14, wherein historical data is analyzed considering at least one of the following information: weather conditions (110), route, aircraft type, flight operator, time schedule or a combination thereof.
